# EUROPEAN PATENT APPLICATION

(11) **EP 4 804 735 A1**
(43) Date of publication of application: **09.09.2026**
(21) Application number: 26161966.2
(22) Date of filing: 03.03.2026
(51) Int. Cl.: H05K 1/02, H05K 3/325, H05K 1/14

(54) **HEATSINK INTEGRATED VOLTAGE REGULATOR ASSEMBLY FOR AN INTEGRATED CIRCUIT PACKAGE**

(30) Priority: 04.03.2025 US 202519069958
(71) Applicant: Google LLC, Mountain View, CA 94043 (US)
(72) Inventor: Roy, Richard Stuart, Mountain View, California, 94043 (US)
(74) Representative: Betten & Resch

(57) **Abstract**

A voltage regulator assembly for an integrated circuit package includes a heatsink positioned above an upper surface of an integrated circuit package. The heatsink defines a cavity above the integrated circuit package and a voltage regulator is positioned inside the cavity defined by the heatsink. A pogo pin pad is positioned between the voltage regulator and integrated circuit package and is configured to transfer a voltage from the voltage regulator to the integrated circuit package. Also provided is a method of regulating voltage for an integrated circuit package using such a voltage regulator assembly.

## Description

### BACKGROUND

Advancements in the semiconductor industry have led to the prevalent use of integrated circuits with higher computing power which are powered using voltage regulators. Typical voltage regulators for integrated circuits are positioned adjacent to the integrated circuit on a printed circuit board and often have power delivery issues due to the high power usage of the integrated circuit or transient support requirements. Consequently, a voltage regulator with increased efficiency and stability is needed to power such high power integrated circuits.

### BRIEF SUMMARY

Aspects of this disclosure are directed to a voltage regulator assembly for an integrated circuit package and a method for regulating voltage for an integrated circuit package. The voltage regulator assembly includes a heatsink having an integrated voltage regulator positioned above an integrated circuit package, where the voltage regulator is connected to the integrated circuit package using pogo pin pads.

One aspect of the disclosure is directed to a voltage regulator assembly for an integrated circuit package includes a heatsink positioned above an upper surface of an integrated circuit package, the heatsink defining a cavity above the integrated circuit package, a voltage regulator positioned inside the cavity defined by the heatsink, and a pogo pin pad positioned between the voltage regulator and the integrated circuit package. The pogo pin pad transfers a voltage from the voltage regulator to the integrated circuit package.

In some arrangements, the cavity defined by the heatsink includes an upper opening.

In some arrangements, the voltage regulator includes a first stage and a second stage.

In some arrangements, the first stage of the voltage regulator is configured to convert a high voltage to an intermediate voltage.

In some arrangements, the second stage of the voltage regulator is configured to convert an intermediate voltage to a low voltage.

In some arrangements, the assembly further includes a thermal interface material layered between the heatsink and the upper surface of the integrated circuit package, the thermal interface material including a thermally conductive pad, putty, or grease configured to transfer heat from the integrated circuit package to the heatsink.

In some arrangements, the heatsink may include fins, a cold plate, or a liquid cooling system.

In some arrangements, the heatsink may include a thermosyphon heatsink or a heat pipe heatsink.

In some arrangements, the pogo pin pad is plated with gold.

In some arrangements, the heatsink includes a hole on a lower surface of the heatsink and the pogo pin pad is configured to extend through the hole on the heatsink.

In some arrangements, the pogo pin pad has a first end configured to engage the voltage regulator and a second end configured to engage the upper surface of the integrated circuit package.

In some arrangements, one or both of the first or second end of each of the pogo pin pads is spring loaded.

In some arrangements, the integrated circuit package is stacked on a printed circuit board, and the integrated circuit package is attached to the printed circuit board through a ball grid array.

In some arrangements, the voltage regulator is connected to the printed circuit board using a cable.

In some arrangements, the assembly further includes a plurality of pogo pin pads.

In some arrangements, the cable transmits a high voltage low current into the voltage regulator which converts the high voltage low current into a low voltage high current and transmits into the integrated circuit package using the pogo pin pad.

Another aspect of the disclosure is directed to a method of regulating voltage for an integrated circuit package, including: receiving, by a voltage regulator, a high voltage with a low current; reducing the high voltage with a low current to a low voltage with a high current using the voltage regulator, wherein the voltage regulator is positioned within a cavity of a heatsink positioned above an upper surface of the integrated circuit package; and transferring the low voltage with a high current to the integrated circuit package using a pogo pin pad, wherein a first end of the pogo pin pad engages the voltage regulator and a second end of the pogo pin pad engages the upper surface of the integrated circuit package.

In some arrangements, reducing the high voltage further comprises reducing the high voltage to an intermediate voltage and then reducing the intermediate voltage to a low voltage.

In some arrangements, the method further includes regulating, using the heatsink, a temperature the voltage regulator and a temperature of the integrated circuit package.

In some arrangements, the method further includes directly transmitting the high voltage to the voltage regulator assembly on the integrated circuit package

### BRIEF DESCRIPTION OF THE DRAWINGS

In the drawings, which are presented in simplified form and are not drawn to precise scale:
Fig. 1 is a cross-sectional side view of an example voltage regulator assembly for an integrated circuit according to aspects of the disclosure.
Fig. 2 is a top view of the integrated circuit of Fig. 1 without a heatsink and a voltage regulator.
Fig. 3 is a flow chart illustrating a method of regulating voltage for an integrated circuit package.

### DETAILED DESCRIPTION

### Overview

Aspects of the disclosure relate to a voltage regulator assembly for an integrated circuit package and a method of regulating voltage for an integrated circuit package using a voltage regulator housed within a heatsink stacked on an integrated circuit package.

The voltage regulator assembly includes a heatsink positioned above an upper surface of an integrated circuit package. The heatsink defines a cavity above the integrated circuit package and the voltage regulator is positioned within the heatsink cavity. For example, the heatsink may include a base and one or more sidewalls coupled to or adjacent to the base, such that the one or more sidewalls and the base together create a cavity. A pogo pin pad connects the upper surface of the integrated circuit package to the voltage regulator to transfer voltage directly from the voltage regulator into the integrated circuit package. The pogo pin pad may extend through an opening along the heatsink to allow for such a direct transfer of voltage from the voltage regulator to the integrated circuit package.

The voltage regulator assembly regulates voltage for the integrated circuit package by receiving a high voltage with a lower current and reducing this high voltage to a low voltage with a high current. The low voltage is then transferred directly into the integrated circuit package from the voltage regulator using one or more pogo pin pads connecting the voltage regulator to the integrated circuit package. The heatsink is positioned between the voltage regulator and the integrated circuit package and is able to effectively cool and regulate the temperature of both the voltage regulator and the integrated circuit package during operation, promoting voltage stability and preventing die malfunction.

Such a heatsink integrated voltage regulator assembly allows for flexibility of placement of the integrated circuit package on the printed circuit board, minimizes component and assembly costs, and solves challenges such as aging, thermal expansion, and oxidation of the integrated circuit and voltage regulator. Integration of the voltage regulator assembly with the heatsink positioned on the integrated circuit package enables direct power transmission between the voltage regulator and the integrated circuit package. Such a short transmission path improves power integrity and efficiency as well as ease of assembly and repair. For example, if the voltage regulator fails it is much easier to swap the voltage regulator assembly instead of reworking the printed circuit board arrangement. In such cases it is possible to unplug a power cable, remove the voltage regulator assembly, and replace it with a spare voltage regulator assembly.

### Voltage Regulator Assembly

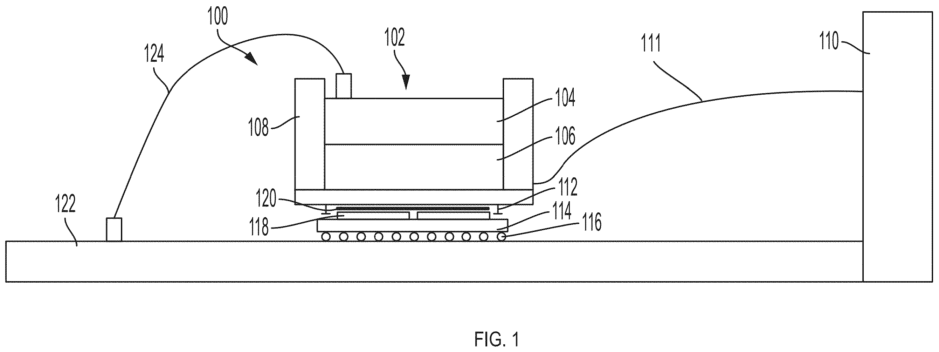

Fig. 1 is a cross-sectional side view of an example voltage regulator assembly 100 for an integrated circuit package 114. As shown in Fig. 1, the voltage regulator assembly 100 includes a heatsink 108 and a voltage regulator 102. The heatsink 108 is positioned above an upper surface of the integrated circuit package 114. The heatsink 108 defines a cavity above the integrated circuit package 114 and a voltage regulator 102 is positioned within the cavity defined by the heatsink. The voltage regulator assembly 100 also includes one or more pogo pin pads 112 positioned between the voltage regulator 102 and the integrated circuit package 114.

As shown in Fig. 1, in some examples, the voltage regulator assembly 100 may be used in combination with the integrated circuit package 114. Use of the voltage regulator assembly is not limited as such, and the assembly may be used in combination with any application specific integrated circuits. The integrated circuit package 114 may include a chip 118 positioned on an upper surface of the integrated circuit package. A thermal interface material 120 may be layered on an upper surface of the chip 118 and the heatsink 108 may be positioned directly on an upper surface of the thermal interface material.

The integrated circuit package 114 may be attached to a printed circuit board 122 using a ball grid array 116 positioned between a bottom surface of the integrated circuit package and an upper surface of the printed circuit board. The voltage regulator 102 may be connected to the printed circuit board 122 using a power cable 124 able to transmit a high voltage at a low current from the printed circuit board to the voltage regulator. In other examples, the power cable 124 may transmit a high voltage from an off-board source other than the printed circuit board.

The voltage regulator assembly increases the overall efficiency and reliability of the integrated circuit package. The structure and positioning of the voltage regulator assembly on the integrated circuit package allows for a relatively high voltage to travel directly to the integrated circuit package. The voltage regulator receives the high voltage which is then stepped down to a lower voltage and then transferred into the integrated circuit package. In some examples, as shown in Fig. 1, the voltage regulator 102 may include a first stage 104 and a second stage 106. The first stage 104 of the voltage regulator 102 is configured to convert a high voltage to an intermediate voltage. For example, the first stage 104 may reduce a high voltage of a range of substantially or approximately 30V to 60V to an intermediate voltage. The intermediate voltage may include a fixed ratio division or fixed voltage. In some examples, an output or intermediate voltage of the first stage may be in a range of substantially or approximately 6V to 14.4V. The second stage 106 of the voltage regulator is configured to convert an intermediate voltage to a low voltage. For example, the output or intermediate fixed voltage of the first stage in the range of substantially or approximately 6V to 14.4V may be lowered to a second stage output or low voltage in a range of substantially or approximately 0.7V to 3.3V. In other examples, the voltage regulator may only include one stage configured to convert a high voltage to a lower voltage. The ranges and values provided herein are merely examples and are not intended to be limiting.

In some examples, as shown in Fig. 1, the heatsink 108 may define a cavity having a box-like structure with an upper opening. In some examples, the heatsink 108 may include a single unit. In such examples, the heatsink 108 includes a metal plate and a fin stack for increasing surface area for heat dissipation. The metal plate may be made of copper. In other examples, as shown in Fig. 1, the heatsink 108 may include a thermosyphon or heat pipe heatsink having a second heatsink component 110. In some examples, second heatsink component 110 may include a finned condenser that is attached to the heatsink 108 using tubing 111. In such an example, heatsink 108 contains a fluid that is evaporated at a bottom of the heatsink and the resulting vapor flows through the tubing 111 to the second heatsink component 110. The vapor condenses is the second heatsink component 110 and the condensed vapor returns as a fluid to heatsink 108 through the tubing 111. The tubing 111 may include copper tubing. However, the structure of the heatsink is not limited as such and other types of heatsinks may be used in combination with the voltage regulator. For example, the heatsink may include one or more of fins, a cold plate, a liquid cooling system, or a traditional heat pipe system.

The heatsink 108 may be used in combination with the thermal interface material 120 layered on the upper surface of the chip 118. The thermal interface material 120 is used to increase heat transfer from the integrated circuit package to the heatsink. The thermal interface material 120 may include any thermally conductive material, which may take form as a pad, putty, grease-like material, etc.

The positioning of the heatsink allows for dual temperature regulation of the voltage regulator and the integrated circuit package at the same time. The heatsink 108, as shown in Fig. 1, is positioned on top of the thermal interface material 120 which is layered on the chip 118 of the integrated circuit package 114. The voltage regulator 102 is housed within the heatsink 108. As such, the heatsink 108 is directly connected to the integrated circuit package 114 and the voltage regulator 102. In some examples, a lower surface of the heatsink 108 may have an area larger than an area of the upper surface of the integrated circuit package 114 in order to maximize the transfer of heat from the integrated circuit package.

The lower surface of the heatsink 108 may include one or more holes or openings configured to house the pogo pin pads 112. Each pogo pin pad 112 is configured to extend through such an opening in the heatsink 108 to allow for direct voltage transfer from the voltage regulator 102 to the upper surface of the integrated circuit package 114.

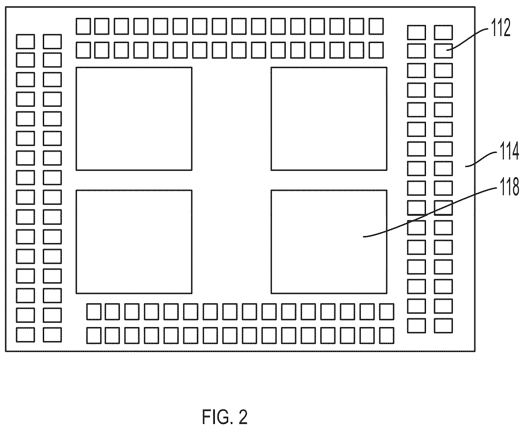

Fig. 2 is a top view of the integrated circuit package, without the voltage regulator and the heatsink, illustrating an example arrangement of multiple chips 118 and pogo pin pads 112. In some examples, as shown in Fig. 2, the pogo pin pads may be arranged around an outer perimeter of the chips 118. In some examples, the integrated circuit package 114 may include multiple chips 118. For example, four chips 118 may be positioned on the upper surface of the integrated circuit package 114 arranged in a rectangular formation, as shown in Fig. 2. In other examples the integrated circuit package may have a single chip. In some examples, the chip may include an exposed silicon die. In other examples, the chip may include a metal lid covering a silicon die.

One or more rows of pogo pin pads 112 may be positioned along each edge of the upper surface of the integrated circuit package 114. The pogo pin pads 112 may be arranged side by side in each line. The pogo pin pads 112 may be positioned anywhere on the upper surface of the integrated circuit package 114 are not limited by the example shown in Fig. 2. For example, the pogo pin pads 112 may be placed along the middle of the upper surface of the integrated circuit package 114.

Each pogo pin pad 112 may include a first end configured to engage the voltage regulator 102 and a second end configured to engage the upper surface of the integrated circuit package 114. In some examples, the pogo pin pads 112 may be spring loaded on one or both ends to maximize contact between a first end of the pogo pin pad and the voltage regulator 102, and/or between a second end of the pogo pin pad and the integrated circuit package 114. In some examples, the pogo pin pads 112 may be gold plated to increase the electrical conductivity and aid in voltage transfer from the voltage regulator 102 to the integrated circuit package 114. Pogo pin pads 112 are configured to connect the voltage regulator 102 with the integrated circuit package 114. Power or voltage is delivered through the ends of the pogo pin pads 112.

### Method of Regulating Voltage

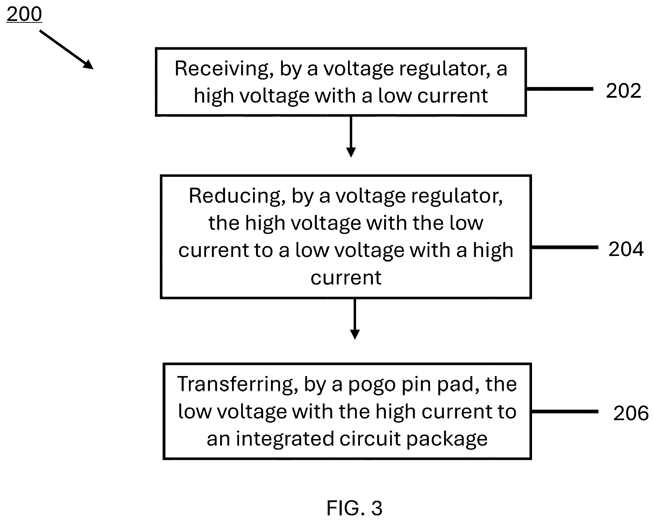

Another aspect of this disclosure relates to a method 200 of regulating voltage for an integrated circuit package using a voltage regulator assembly, as shown in Fig. 3. Such a method 200 is described herein with respect to the example voltage regulator assembly 100 as shown in Figs. 1 and 2. The method 200 of regulating voltage includes a step 202 of receiving, by a voltage regulator 102, a high voltage with a low current, a step 204 of then reducing, by the voltage regulator, the high voltage with a low current to a low voltage with a high current, and a step 206 of transferring the reduced low voltage with a high current from the voltage regulator 102 to the upper surface of the integrated circuit package 114 using one or more pogo pin pads 112.

In some examples, as shown in Fig. 1, the method 200 of reducing the high voltage may further include reducing the high voltage to an intermediate voltage in a first stage 104 of the voltage regulator 102, and then reducing the intermediate voltage to a low voltage in a second stage 106 of the voltage regulator. For example, power may be directly transmitted into the voltage regulator assembly 100 stacked on the integrated circuit package 114 using a power cable 124. The power cable 124 extends from the printed circuit board 122 to the voltage regulator 102.

The high voltage power will be received in the first stage of the voltage regulator which then reduces the high voltage to an intermediate voltage. In some examples, the high voltage may be in a range of substantially or approximately 38V to 65V and may be reduced to an intermediate voltage in a range of substantially or approximately 8V to 24V. The high voltage and intermediate voltage may vary depending on the needs of the integrated circuit package and the voltage regulator. This intermediate voltage moves to the second stage of the voltage regulator which reduces the intermediate voltage to a low voltage. In some examples, the low voltage may be in a range of substantially or approximately 0.6V to 5V. The low voltage may be reduced to different levels depending on the requirements of the integrated circuit package 114. The low voltage from the second stage of the voltage regulator is transferred directly down to the integrated circuit package positioned underneath the heatsink using one or more pogo pin pads. In other examples, the voltage regulator may only include one stage directly reducing the high voltage to a low voltage which then is transmitted to the integrated circuit package using one or more pogo pin pads. Such a voltage regulator assembly allows for direct transfer of a high voltage to the integrated circuit package stack including the integrated heatsink voltage regulator assembly.

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many examples. Further, the same reference numbers in different drawings can identify the same or similar elements.

## Claims

1. A voltage regulator assembly for an integrated circuit package, comprising:
a heatsink positioned above an upper surface of an integrated circuit package, the heatsink defining a cavity above the integrated circuit package;
a voltage regulator positioned inside the cavity defined by the heatsink; and
a pogo pin pad positioned between the voltage regulator and the integrated circuit package, the pogo pin pad being configured to transfer a voltage from the voltage regulator to the integrated circuit package.

2. The assembly of claim 1, wherein the cavity defined by the heatsink includes an upper opening.

3. The assembly of claim 1 or claim 2, wherein the voltage regulator includes a first stage and a second stage.

4. The assembly of claim 3, wherein the first stage of the voltage regulator is configured to convert a high voltage to an intermediate voltage.

5. The assembly of claim 3, wherein the second stage of the voltage regulator is configured to convert an intermediate voltage to a low voltage.

6. The assembly of any one of claims 1 to 5, further comprising a thermal interface material layered between the heatsink and the upper surface of the integrated circuit package, the thermal interface material including a thermally conductive pad, putty, or grease configured to transfer heat from the integrated circuit package to the heatsink.

7. The assembly of any one of claims 1 to 6, wherein the heatsink may include fins, a cold plate, or a liquid cooling system; and/or
wherein the heatsink may include a thermosyphon heatsink or a heat pipe heatsink; and/or
wherein the pogo pin pad is plated with gold; and/or
wherein the heatsink includes a hole on a lower surface of the heatsink and the pogo pin pad is configured to extend through the hole on the heatsink.

8. The assembly of any one of claims 1 to 7, wherein the pogo pin pad has a first end configured to engage the voltage regulator and a second end configured to engage the upper surface of the integrated circuit package.

9. The assembly of claim 8, wherein one or both of the first or second end of each pogo pin pad is spring loaded.

10. The assembly of any one of claims 1 to 9, wherein the integrated circuit package is stacked on a printed circuit board, and the integrated circuit package is attached to the printed circuit board through a ball grid array.

11. The assembly of claim 10, wherein the voltage regulator is connected to the printed circuit board using a cable.

12. The assembly of any one of claims 1 to 11, further comprising a plurality of pogo pin pads.

13. The assembly of claim 11 or claim 12, wherein the cable transmits a high voltage low current into the voltage regulator which converts the high voltage low current into a low voltage high current and transmits into the integrated circuit package using the pogo pin pad.

14. A method of regulating voltage for an integrated circuit package, comprising:
receiving, by a voltage regulator, a high voltage with a low current;
reducing the high voltage with a low current to a low voltage with a high current using the voltage regulator, wherein the voltage regulator is positioned within a cavity of a heatsink positioned above an upper surface of the integrated circuit package; and
transferring the low voltage with a high current to the integrated circuit package using a pogo pin pad, wherein a first end of the pogo pin pad engages the voltage regulator and a second end of the pogo pin pad engages the upper surface of the integrated circuit package.

15. The method of claim 14, wherein reducing the high voltage further comprises reducing the high voltage to an intermediate voltage and then reducing the intermediate voltage to a low voltage; and/or
further comprising regulating, using the heatsink, a temperature the voltage regulator and a temperature of the integrated circuit package; and/or
further comprising directly transmitting the high voltage to the voltage regulator on the integrated circuit package.
